# EUROPÄISCHE PATENTSCHRIFT

(11) **EP 0 937 261 B1**
(45) Veröffentlichungstag und Bekanntmachung des Hinweises auf die Patenterteilung: **25.06.2003**
(21) Anmeldenummer: 98928067.2
(22) Anmeldetag: 25.03.1998
(51) Int. Cl.: G01P 3/487, G01D 5/14

(54) **SENSOREINRICHTUNG**
SENSOR DEVICE
DISPOSITIF DETECTEUR

(30) Priorität: 10.09.1997 DE 19739682
(43) Veröffentlichungstag der Anmeldung: 25.08.1999
(73) Patentinhaber: ROBERT BOSCH GMBH, 70442 Stuttgart (DE)
(72) Erfinder: WEBER, Matthias, D-76534 Baden-Baden (DE); KNAB, Norbert, D-77767 Appenweier (DE); KLAPPENBACH, Christoph, D-77815 Bühl (DE); RIEHL, Guenther, D-77830 Bühlertal (DE); HAGER, Martin, D-77830 Bühlertal (DE); DREIER, Friedrich-Wilhelm, D-76547 Sinzheim (DE); SOELLNER, Michael, 0-77836 Rheinmünster (DE); BOCK, Olaf, D-77815 Bühl (DE)
(86) Internationale Anmeldenummer: DE9800871
(87) Internationale Veröffentlichungsnummer: WO99013341

(56) Entgegenhaltungen:
- EP-A- 0 387 854
- WO-A-96/41120
- DE-A- 19 525 292
- US-A- 5 589 664

## Beschreibung

### Stand der Technik

Die Erfindung betrifft eine Sensoreinrichtung mit den im Oberbegriff des Anspruchs 1 angegebenen Merkmalen.

Derartige Sensoreinrichtungen werden beispielsweise in Elektromotoren zur Erfassung verschiedener von der Drehbewegung der Motorankerwelle abhängiger Größen, wie z.B. Drehzahl, Drehrichtung oder Drehwinkel, eingesetzt und sind zum Beispiel aus der DE 195 25 292 A1 bekannt. Ein Permanentmagnet ist auf einer Leiterplatte im Elektronikraum des Elektromotors angeordnet. Die beiden Pole des Magneten sind mit Magnetflußleitern verbunden, die bis zu der von dem Elektronikraum entfernt angeordneten Motorankerwelle geführt sind, wo je ein Endabschnitt der Magnetflußleiter durch einen schmalen Luftspalt von einem mit der Motorankerwelle bewegten Magnetflußwandler beabstandet ist. Der bewegte Magnetflußwandler umfaßt ferromagnetische und diamagnetische Abschnitte, die auf einem Rotationskörper angeordnet sind. Eine Drehung der Motorankerwelle führt zu einer Rotation des Magnetflußwandlers, wodurch sich der magnetische Fluß in dem durch den Permanentmagneten, die Magnetflußleiter und den Magnetflußwandler gebildeten Magnetkreis ändert. Ein auf der Leiterplatte über dem Permanentmagneten angeordneter Hallsensor erfaßt die Magnetfeldänderung des sich verändernden Streufeldes und erzeugt in Abhängigkeit von der Änderung ein elektrisches Ausgangssignal, daß einer mit dem Hallsensor verbundenen Motorsteuerschaltung zugeführt wird.

Weiterhin sind Sensoreinrichtungen zur Verwendung in einem Elektromotor bekannt, bei denen der mit der Motorwelle bewegte Magnetflußwandler aus einem mit der Motorankerwelle drehfest verbundenen als Ringmagnet ausgestalteten Permanentmagneten besteht, der zugleich die Magnetfeldquelle ist. Ortsfeste Magnetflußleiter sind mit ihren als Abgriff vorgesehenen Enden dem Ringmagnet zugewandt. Das andere, von der Motorankerwelle mit dem Magnetflußwandler abgewandte Ende der Magnetflußleiter ist einem Hall-IC zugeordnet, der als oberflächenmontiertes SMD-Bauelement beispielsweise auf einer Leiterplatte in einem Elektronikraum des Elektromotors angeordnet ist. Eine Drehung der Motorankerwelle führt auch hier zu einer Änderung des in dem Magnetflußleiter induzierten Magnetflußes und damit zu einer Änderung des durch den Hall-IC erfaßten Magnetfeldsignals. Der Hall-IC wandelt das Signal in ein digitales elektrisches Signal um, welches von der auf der Leiterplatte angeordneten Motorsteuerelektronik ausgewertet und zur Motorsteuerung benutzt wird. Eine derartige Sensoreinrichtung ist aus der WO 96/41120 bekannt.

### Vorteile der Erfindung

Die erfindungsgemäße Sensoreinrichtung mit den kennzeichnenden Merkmalen des Anspruchs 1 hat demgegemüber den Vorteil, daß der für die Unterbringung der Hallsensoren und der elektronischen Steuerschaltung benötigte Platz auf dem hierfür vorgesehenen Trägerteil, das beispielsweise eine Leiterplatte sein kann, erheblich reduziert werden kann. So können zur Steuerelektronik gehörende Schaltungsteile, wie beispielsweise Programmspeicher, Mikroprozessor oder EPROM mit dem Hall-IC-Bauelement in einem anwenderspezifischen integrierten Schaltkreis (ASIC) zusammengefaßt werden, der als einzelnes Bauelement auf die Leiterplatte bestückt wird. Hierdurch wird der Bestückungsaufwand der Leiterplatte erheblich verringert, so daß insgesamt Kosten eingespart werden können. Kosteneinsparungen resultieren auch daraus, daß die Herstellung eines einzelnen ASIC-Bauelementes erheblich preiswerter ist, als die Herstellung einer Leiterplatte, auf die alle für die elektronische Schaltung benötigten Baukomponenten einzeln bestückt werden. Vorteilhaft werden die magnetischen Signale durch die Magnetflußleiter direkt auf den Hallsensorteil des anwenderspezifischen integrierten Schaltkreises übertragen. Das ASIC-Bauelement kann so entfernt von mechanisch beweglichen Teilen, wie z.B. der Motorankerwelle eines Elektromotors, und vor Verschmutzungen und Feuchtigkeit geschützt angeordnet werden. Darüber hinaus kann das kleine ASIC-Bauelement leichter vor Feuchtigkeit und Verschmutzung geschützt werden als eine komplexe, auf einer Leiterplatte angeordnete elektronische Schaltung, wodurch sich insgesamt auch die Zuverlässigkeit erhöht.

Weitere vorteilhafte Ausgestaltungen und Weiterentwicklungen der Erfindung sind in den Merkmalen der Unteransprüche enthalten. So ist es vorteilhaft, das ASIC-Bauelement auf einem Trägerteil entfernt vom Magnetfeldwandler zwischen den Enden zweier Magnetflußleiter anzuordnen, da so das magnetische Feld optimal von dem in dem ASIC-Bauelement enthaltenen Hallsensorteil erfaßt wird.

Dadurch, daß ein Vorsprung eines Magnetleiters durch eine Ausnehmung des Trägerteils zur Montagefläche des ASIC-Bauelementes hindurchgeführt wird, kann die Magnetfelderfassung durch den Hallsensorteil des ASIC-Bauelements noch verbessert werden.

Besonders vorteilhaft ist, daß die Magnetflußleiter nicht nur als Signalleiter, sondern darüber hinaus auch als Kühlkörper zur Abfuhr der von dem ASIC-Bauelement erzeugten Wärme dienen können, wenn die Magnetflußleiter in einem wärmeleitenden Kontakt mit dem ASIC-Bauelement stehen.

### Zeichnung

Ein Ausführungsbeispiel der Erfindung ist in der Zeichnung dargestellt und wird in der nachfolgenden Beschreibung näher erläutert. Es zeigt
Fig. 1 eine Prinzipdarstellung eines Teils einer Sensoreinrichtung eines Elektromotors mit dem Magnetflußwandler, den Magnetflußleitern und einer Leiterplatte nach dem Stand der Technik,
Fig. 2 eine teilweise geschnittene Ansicht des erfindungsgemäßen Sensoreinrichtung.

### Beschreibung des Ausführungsbeispiels

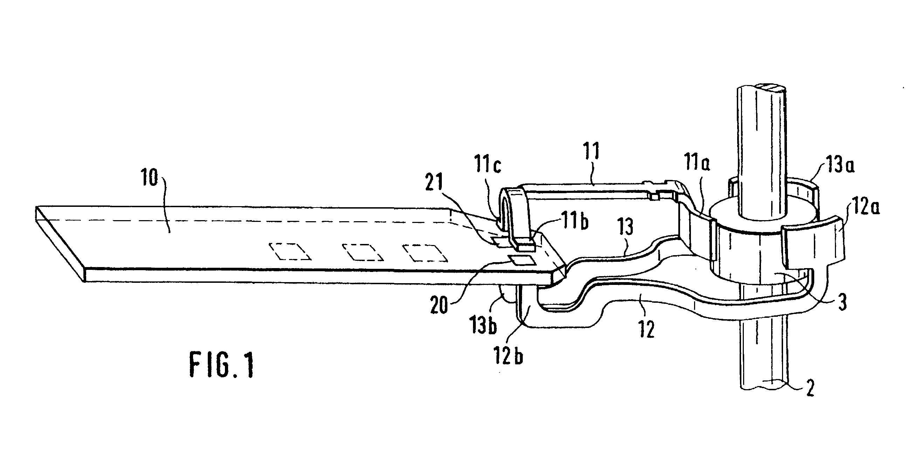

Fig. 1 zeigt eine Prinzipdarstellung eines Teils einer bekannten Sensoreinrichtung, die beispielsweise in einem Elektromotor angeordnet ist. Der nicht dargestellte Drehantrieb des Motors ist über eine Motorankerwelle 2 mit dem ebenfalls nicht dargestellten Motorgetriebe verbunden. Auf der Motorankerwelle 2 ist als Magnetflußwandler ein magnetischer Polring 3 angeordnet, der zur Hälfte aus einem Nordpol und einem Südpol besteht. Der magnetische Polring dient zugleich als Magnetflußquelle und als Magnetflußwandler. Weiterhin weist die Sensoreinrichtung drei ortsfeste Magnetflußleiter 11,12, 13 auf, die aus weichmagnetischen Material mit hoher Permeabilität bestehen. Die der Motorankerwelle zugewandten Endabschnitte 11a, 12a und 13a der Magnetflußleiter sind in ihrer Kontur dem Polring 3 angepaßt und durch einen schmalen Luftspalt von dem Polring beabstandet. Die Magnetflußleiter 11, 12,13 sind in einem in Fig. 1 nicht gezeigten Bürstenteil angeordnet, das sich zwischen dem Drehantrieb und dem Motorgetriebe befindet. Das Bürstenteil dient der Halterung von Kohlebürsten, die mit einem auf der Motorankerwelle angeordneten Kommutator in elektrischen Kontakt stehen und zur Motorstromkontaktierung vorgesehen sind. Mit dem Bürstenteil ist ein Elektronikgehäuse verbunden, in dem eine Leiterplatte 10 mit einer elektronischen Schaltung zur Motorsteuerung angeordnet ist. Die Magnetflußleiter 11,12,13 sind in dem Bürstenteil bis zu dem Elektronikgehäuse und der Leiterplatte 10 geführt, auf der zwei Hall-IC-Elemente 20,21 angeordnet sind. Das Ende des Magnetflußleiters 11 gabelt sich über der Leiterplatte in zwei Endabschnitte 11b und 11c. Die von der Motorwelle abgewandten Endabschnitte 11b und 12b der Magnetflußleiter 11 und 12 enden oberhalb und unterhalb des Hall-IC-Elementes 20, die Endabschnitte 11c und 13b der Magnetflußleiter 11 und 13 enden oberhalb und unterhalb des Hall-IC-Elementes 21. Bei einer Drehung der Motorankerwelle 2 ändert sich der magnetische Fluß, welcher in dem aus dem Magnetflußleiter 3, den ortsfesten Magnetflußleitern 11 und 12 und dem Hall-IC 20 gebildeten Magnetkreis induziert wird. Entsprechendes gilt für den aus den Magnetflußleitern 11 und 13 und dem Hall-IC 21 gebildeten zweiten Magnetkreis. Die Änderung des Magnetfeldes wird von den Hall-IC-Elementen 20,21 in ein digitales elektrisches Signal umgewandelt und der auf der Leiterplatte 10 vorgesehenen elektronischen Steuerschaltung zugeführt. Diese wertet das Signal in einem Logikteil mit Hilfe eines programmgesteuerten Mikroprozessors oder Mikrocontrollers aus und steuert auf der Leiterplatte vorgesehen Relais an, welche die Stromzufuhr des Elektromotors regeln. Die Stromzufuhr erfolgt über mit der Motorankerwelle 2 über die Kohlefaserbürsten verbundene Stromleiter, welche z.B. die Magnetflußleiter 11,12,13 umhüllen können.

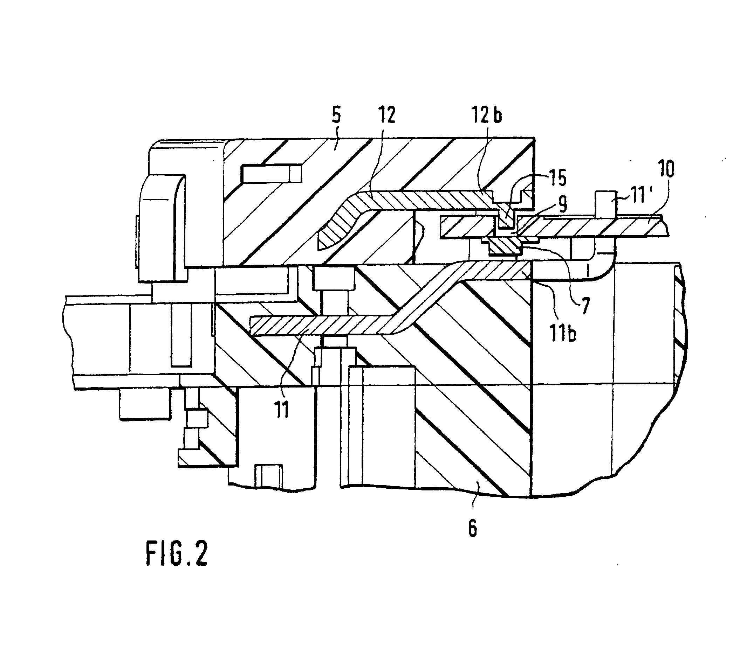

Fig. 2 zeigt eine Teilansicht der erfindungsgemäßen Sensoreinrichtung im Querschnitt. Die Sensoreinrichtung ist hier ebenfalls in einem Elektromotor angeordnet. Es ist aber auch möglich die Sensoreinrichtung z.B. in einem Getriebe mit einem linear bewegten und nicht rotierenden Magnetflußwandler zu verwenden. Dargestellt ist ein Ausschnitt des aus Kunststoff gefertigten Bürstenhalters 6 des Elekromotors, in dem der Magnetflußleiter 11 angeordnet ist. Auf dem Bürstenhalter 6 ist ein weiteres Bauteil 5 aus Kunststoff mit zwei Magnetflußleitern 12 und 13 montiert, von denen in Fig. 2 nur der Magnetflußleiter 12 dargestellt ist. Mit dem Bürstenhalter 6 ist ein Trägerteil 10 verbunden, welches als kleine Leiterplatte oder als ein mit Kunststoff umspritztes Stanzgitter ausgebildet sein kann. Das Bürstenteil 6 ist so in dem Elektromotor angeordnet, daß das Trägerteil 10 von der Motorankerwelle entfernt in einem Elektronikraum angeordnet ist. Der Elektronikraum weist einen nicht dargestellten Stecker mit Kontaktelementen auf, die mit der Steuerschaltung auf der Leiterplatte 10 elektrisch verbunden sind und über externe Kabel an das zentrale Steuergerät beispielsweise eines Kraftfahrzeuges angeschlossen werden.

Wie in Fig. 1 sind bei der in Fig. 2 gezeigten Sensoreinrichtung die Magnetflußleiter so in dem Bürstenteil 6 und dem Bauteil 5 angeordnet, daß ihre Endabschnitte 11b, 12b der Leiterplatte 10 zugeordnet sind, während ihre entgegengesetzten Enden 11a, 12a der Motorankerwelle zugewandt sind. Wie in Fig. 2 zu erkennen ist, sind die Enden 11a und 12a der Magnetflußleiter im Querschnitt nicht sichtbar, da die Magnetflußleiter im Bürstenhalter 6 und dem Bauteil 5 aus der Papierebene nach vorn bzw. nach hinten abgebogen sind und wie in Fig. 1 um den als Magnetflußwandler vorgesehenen beweglichen magnetischen Polring herum angeordnet sind. Wie in Fig. 2 weiterhin dargestellt ist, befindet sich ein Bauelement 7 auf der Leiterplatte 10, welches einen anwenderspezifischen integrierten Schaltkreis (ASIC) enthält. In dem Schaltkreis des Bauelementes 7 sind zwei Hall-IC's und die zur Motorsteuerung benötigte Steuerschaltung mit dem gesamten Logikteil zu einer einzigen integrierten Schaltung zusammengefaßt. Mikroprozessor oder Mikrokontroller und Speicherbauteile sind in dem ASIC integriert und müssen nicht als separate Bauteile auf die Leiterplatte 10 bestückt werden. Das ASIC-Bauelement 7 ist in bekannter Weise auf die Leiterplatte 10 aufgelötet. Wie in Fig. 2 weiterhin zu erkennen ist, ist unterhalb der Montagefläche des ASIC-Bauelementes 7 eine Ausnehmung 9 in der Leiterplatte 10 vorgesehen, durch die ein Vorsprung 15 des Endabschnittes 12b des Magnetflußleiters 12 bis kurz vor die Montagefläche des ASIC-Bauelementes 7 hindurchragt. Entsprechend ist der zweite Magnetflußleiter 13 durch eine zweite nicht dargestellte Ausnehmung zu dem ASIC-Bauelement 7 hindurchgeführt. Das Ende des dritten Magnetflußleiters 11 gabelt sich in zwei Endabschnitte 11b und 11c, die um die der Montagefläche des ASIC-Bauelementes 7 gegenüberliegende Fläche herumgeführt und zur Leiterplatte 10 hin abgebogen sind. Die abgebogenen Enden 11' sind zur Halterung der Leiterplatte 10 durch je eine weitere Ausnehmung der Leiterplatte hindurchgeführt. Wie in Fig. 2 zu erkennen ist, wird das ASIC-Bauelement 7 von den Endabschnitten 11b und 12b bzw. den Endabschnitten 11c und 13b der Magnetflußleiter zangenartig umgriffen. Die beiden Hallsensorteile sind dabei in dem ASIC-Bauelement 7 so angeordnet, daß der Magnetfluß zwischen den Vorsprüngen 15 der Magnetflußleiter 12 und 13 und den Enden 11b bzw. 11c des Magnetflußleiters 11 von den Hallsensoren optimal erfaßt wird. Die Magnetflußleiter können auch anders als in dem hier gezeigten Beispiel angeordnet werden. Auch ist es möglich, nur zwei Magnetflußleiter, z.B. die Leiter 11 und 12 in Fig. 2 zu verwenden und in dem ASIC-Bauelement nur einen Hall-IC zu integrieren. Falls erforderlich, können aber auch mehr als zwei Hallsensoren in dem ASIC-Bauelement integriert werden und vier oder fünf Magnetflußleiter verwandt werden. Entscheidend ist, daß eine Änderung des Magnetflusses vom Hallsensorteil des ASIC-Bauelementes in ein digitales Signal umgesetzt wird, das innerhalb des Bauelementes 7 von der integrierten Schaltung ausgewertet wird. Das Ausgangssignal des ASIC-Bauelementes wird zur Relaisansteuerung benutzt. In einem anderen Ausführungsbeispiel ist vorgesehen, keine Relais zur Stromschaltung zu verwenden, sondern stattdessen Hochleistungstransistoren, welche die Motorströme schalten, direkt in das ASIC-Bauelement zu integrieren. Dadurch kann der für die Motorelektronik benötigte Platz auf der Leiterplatte 10 noch weiter reduziert werden.

Die von dem ASIC-Bauelement erzeugte Wärme kann vorteilhaft an die Magnetflußleiter 11,12,13 abgegeben werden, wenn diese in einem Wärmeleitkontakt mit dem ASIC-Bauelement 7 stehen. Dies kann in Fig. 2 zum Beispiel mit einem in den schmalen Luftspalt zwischen den Endabschnitten der Magnetflußleitern und dem ASIC-Bauelement eingebrachten Wärmeleitkleber erreicht werden oder dadurch, daß die Magnetflußleiter direkt mit dem Gehäuse des ASIC-Bauelementes verbunden werden.

## Patentansprüche

1. Sensoreinrichtung, bestehend aus einem als Hallsensor ausgebildeten ortsfest angeordneten Magnetfeldsensor (20, 21), der magnetisch mit wenigstens einem ortsfesten Magnetflußleiter (11,12,13) gekoppelt ist, welcher ein variables Magnetfeld erfaßt und dem Hallsensor (20,21) zuführt, wobei der Hallsensor ein von der Magnetfeldänderung abhängiges elektrisches Signal einer elektronischen Steuerschaltung zuführt, **dadurch gekennzeichnet, daß** der wenigstens eine Hallsensor (20,21) mit wenigstens einem Teil der elektronischen Steuerschaltung zu einem anwenderspezifischen integrierten Schaltkreis (ASIC) zusammengefaßt in einem elektronischen Bauelement (7) angeordnet ist.

2. Sensoreinrichtung nach Anspruch 1, **dadurch gekennzeichnet, daß** das den anwenderspezifischen integrierten Schaltkreis mit dem wenigstens einen Hallsensor enthaltende elektronische Bauelement (7) zwischen den von einem das variable Magnetfeld erzeugenden Magnetflußwandler (3) abgewandten Endabschnitten (11b,12b) wenigstens zweier Magnetflußleiter (11,12) auf einem von dem Magnetflußwandler (3) entfernt positionierten Trägerteil (10) angeordnet ist.

3. Sensoreinrichtung nach Anspruch 2, **dadurch gekennzeichnet, daß** unterhalb der Montagefläche des den anwenderspezifischen integrierten Schaltkreis mit dem wenigstens einen Hallsensor enthaltenden elektronischen Bauelementes (7) eine Ausnehmung (9) in dem Trägerteil (10) vorgesehen ist, in die ein an einem Magnetflußleiter (12) vorgesehener Vorsprung (19) eingreift und daß der andere Magnetflußleiter (11) an der der Montagefläche gegenüberliegenden Fläche des Bauelementes (7) angeordnet ist.

4. Sensoreinrichtung nach einem der vorstehenden Ansprüche, **dadurch gekennzeichnet, daß** wenigstens einer der beiden Magnetflußleiter (11,12) in einem wärmeleitenden Kontakt zu dem den anwenderspezifischen integrierten Schaltkreis mit dem wenigstens einen Hallsensor enthaltenden elektronischen Bauelement (7) steht und die von dem Bauelement erzeugte Verlustwärme abführt.

5. Sensoreinrichtung nach Anspruch 2, **dadurch gekennzeichnet, daß** die Sensoreinrichtung zur Verwendung in einem Elektromotor vorgesehen ist, wobei der Elektromotor eine Motorankerwelle (2) aufweist, auf welcher der Magnetflußwandler (3) angeordnet ist.

## Claims

1. Sensor device, comprising a magnetic field sensor (20, 21) which is in the form of a Hall sensor, is arranged in a fixed position and is magnetically coupled to at least one fixed-position magnetic flux conductor (11, 12, 13) which detects a variable magnetic field and supplies the Hall sensor (20, 21), with the Hall sensor supplying an electrical signal, which is dependent on changes in the magnetic field, to an electronic control circuit, **characterized in that** the at least one Hall sensor (20, 21) is combined with at least a part of the electronic control circuit to form an application specific integrated circuit (ASIC) and is arranged in an electronic component (7).

2. Sensor device according to Claim 1, **characterized in that** the electronic component (7) which contains the application specific integrated circuit with the at least one Hall sensor is arranged between the end sections (11b, 12b), which face away from a magnetic flux transducer (3) which produces the variable magnetic field, of at least two magnetic flux conductors (11, 12) on a mount part (10) which is positioned remotely from the magnetic flux transducer (3).

3. Sensor device according to Claim 2, **characterized in that** a recess (9) is provided in the mount part (10) underneath the mounting surface of the electronic component (7) which contains the application specific integrated circuit with the at least one Hall sensor, in which recess (9) a projection (19), which is provided on a magnetic flux conductor (12), engages, and **in that** the other magnetic flux conductor (11) is arranged on that surface of the component (7) which is opposite the mounting surface.

4. Sensor device according to one of the preceding claims, **characterized in that** at least one of the two magnetic flux conductors (11, 12) makes thermally conductive contact with the electronic component (7) which contains the application specific integrated circuit with the at least one Hall sensor, and dissipates the heat losses produced by that component.

5. Sensor device according to Claim 2, **characterized in that** the sensor device is intended for use in an electric motor, with the electric motor having a motor armature shaft (2) on which the magnetic flux transducer (3) is arranged.

## Revendications

1. Installation de capteur composée d'un capteur de champ magnétique (20, 21) installé de manière fixe, sous la forme d'un capteur Hall, couplé magnétiquement à au moins un conducteur de flux magnétique fixe (11, 12, 13), ce dernier détectant un champ magnétique variable pour le transmettre au capteur Hall (20, 21),
le capteur Hall fournissant un signal électrique dépendant de la variation de champ magnétique à un circuit de commande électronique,
**caractérisée en ce qu'**
au moins un capteur Hall (20, 21) est réuni avec au moins une partie du circuit de commande électronique pour constituer un circuit intégré dédié à une application (circuit ASIC) regroupé dans un composant électronique (7).

2. Installation de capteur selon la revendication 1,
**caractérisée en ce que**
le composant électronique (7) comportant le circuit intégré dédié à une application et ayant au moins un capteur Hall, est installé entre les segments d'extrémité (11b, 12b) opposés au convertisseur de flux magnétique (3) générant le flux magnétique variable, d'au moins deux conducteurs de flux magnétique (11, 12), sur une pièce de support (10) installée dans une position éloignée du convertisseur de flux magnétique (3).

3. Installation de capteur selon la revendication 2,
**caractérisée en ce que**
sous la surface de montage du composant électronique (7) comportant le circuit intégré dédié à une application avec au moins un capteur Hall, la pièce de support (10) comporte une cavité (9) dans laquelle pénètre une saillie (19) d'un conducteur de flux magnétique (12) et l'autre conducteur de flux magnétique (11) est installé contre la surface du composant (7), opposée à la surface de montage.

4. Installation de capteur selon l'une quelconque des revendications précédentes,
**caractérisée en ce qu'**
au moins l'un des deux conducteurs de flux magnétique (11, 12) est en contact de conduction thermique avec le circuit intégré spécifique à l'application, avec un composant électronique (7) comportant au moins un capteur Hall pour évacuer la chaleur dégagée par le composant.

5. Installation de capteur selon la revendication 2,
**caractérisé en ce que**
l'installation de capteur est appliquée à un moteur électrique comportant un arbre d'induit (2) portant le convertisseur de flux magnétique (3).
